# EUROPEAN PATENT APPLICATION

(11) **EP 1 921 903 A2**
(43) Date of publication of application: **14.05.2008**
(21) Application number: 07021654.4
(22) Date of filing: 07.11.2007
(51) Int. Cl.: H05K 1/14, H05K 3/30

(54) **Electric power module**

(30) Priority: 09.11.2006 DE 102006052872
(71) Applicant: Tyco Electronics Raychem GmbH, 85521 Ottobrunn (DE)
(72) Inventor: Ehler, Ralf, 1025 Budapest (HU)
(74) Representative: Grünecker, Kinkeldey, Stockmair & Schwanhäusser Anwaltssozietät

(57) **Abstract**

The present invention relates to an electric power module for assembly on a printed circuit board (46), comprising a circuit carrier (212) and a housing (214) for assembly of a cooling element (45), wherein the circuit carrier (212) is arranged on the printed circuit board (46) so as to be substantially perpendicular thereto in an assembled position of the electric power module. To improve a generic electric power module and a power device that receives this electric power module such that the electric power module has simplified assembly in the electric power device, the electric power module comprises at least one plug-in device (220) for attaching the power module to the printed circuit board (46).

## Description

The present invention relates to an electric power module for assembly on a printed circuit board, comprising a circuit carrier and a housing for assembly of a cooling element, wherein the circuit carrier is arranged on the printed circuit board so as to be substantially perpendicular thereto in an assembled position of the electric power module.

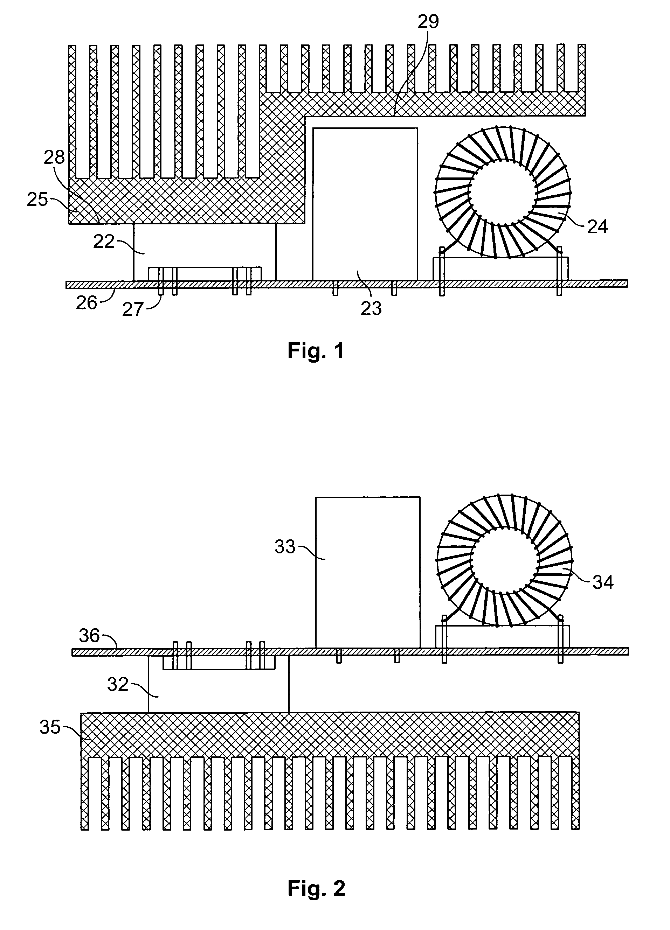

In many applications the previous construction of electric power modules has been a problem in further processing of the power modules and when constructing an electric power device, such as an electronic frequency converter. This is described with reference to figures 1 to 10.

As may be seen from Fig. 1 an electric power device conventionally comprises a printed circuit board 26 on which an electric power module 22 and electronic components, such as capacitors 23 and chokes 24, are assembled. The electric power device is also provided with a heat sink 25 which is used to dissipate heat generated in the electric power module 22.

In known power modules the pins 27 of the electric power module 22 are usually led through with respect to the assembly surface 28 for assembly of the heat sink 25. If the power module 22, the capacitor 23 and the choke 24 are fitted on one side of the printed circuit board 26 all leaded components can be soldered using a solder wave. Since the capacitor 23 and the choke 24 are higher than the power module 22 however, the heat sink 25 only partially covers the printed circuit board 26 or has to be milled out or laboriously recessed at certain points 29 where the higher components are located. This leads to significantly worse heat dissipation, increased complexity and higher production costs for the electric power device.

If, however, the electric power module 32 and the higher components 33, 34 are fitted to opposing sides of the printed circuit board 36, as shown in Fig. 2, then a particular heat sink 35 production method is no longer required. However it is no longer possible to solder all leaded components using a solder wave. Either only the power module 32 or the other leaded components 33, 34 may be soldered by means of a solder wave. The remaining components on the other side of the printed circuit board 36 therefore have to be soldered manually or using a robot, and this involves significant additional complexity and expenditure. The overall height of the construction also increases, whereby the electronic frequency converter can no longer be constructed as narrow as desired.

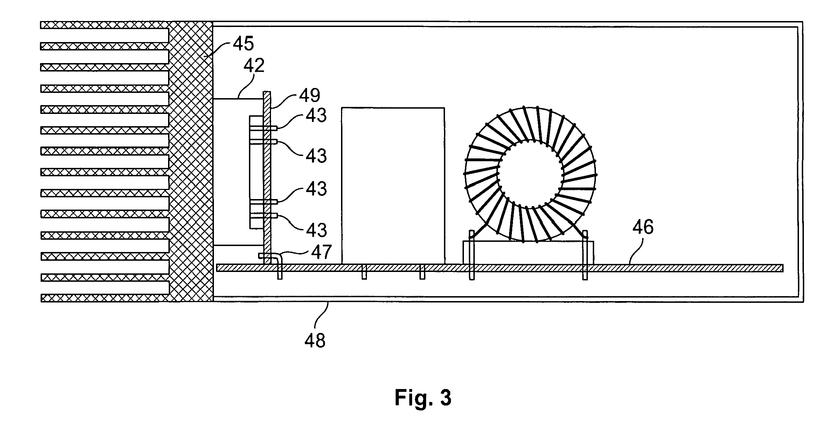

As may be seen from Fig. 3, for cost reasons and so that improved heat dissipation of the electric power device can be achieved, a construction is currently preferred in which the heat sink 45 is located on the back of the electric power device and the printed circuit board 46 runs parallel to a side wall 48 of the electric power device. In previous power modules 42 an additional printed circuit board 49 always had to be used to receive the power module 42. This auxiliary printed circuit board 49 is intended for mounting via additional connecting parts 47 with respect to the main printed circuit board 46, and this has led to increased material costs and high assembly expenditure.

The overall construction of the electric power device shown in Fig. 3 can be simplified by leading through the connecting pins 43 of the electric power module 42 laterally rather than perpendicularly to the assembly surface of the heat sink 45. Use of an auxiliary printed circuit board 49 and additional connecting parts 47 is consequently omitted.

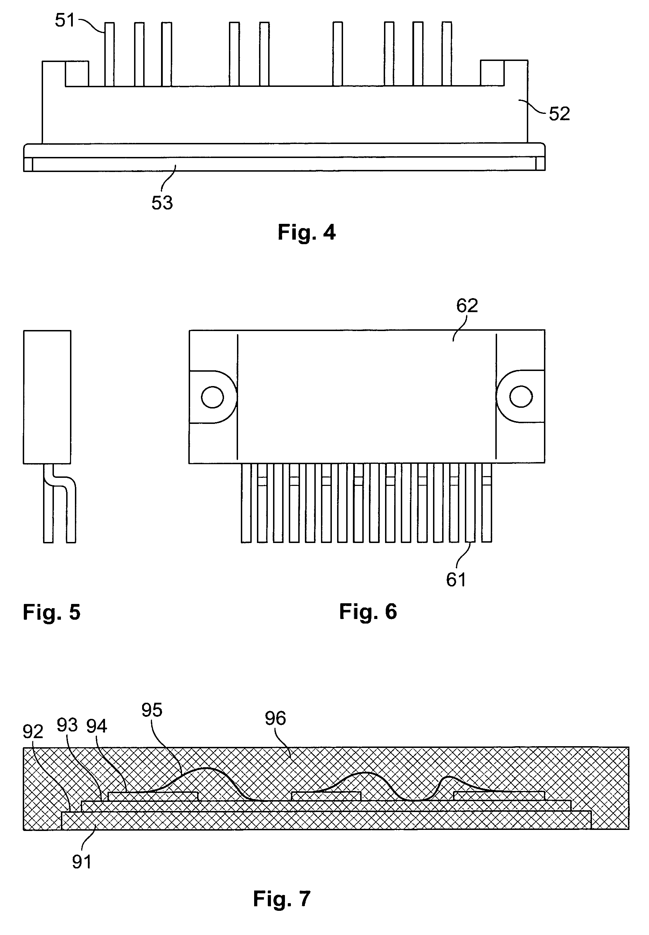

Fig. 4 shows a previously known power module 42 in which the pins 51 are perpendicular to the assembly surface 53 of the heat sink. In contrast thereto the pins 61 of an electric power module 62 with lateral pin design are arranged substantially parallel to a plane of the assembly surface of a heat sink, as shown in figures 5 and 6.

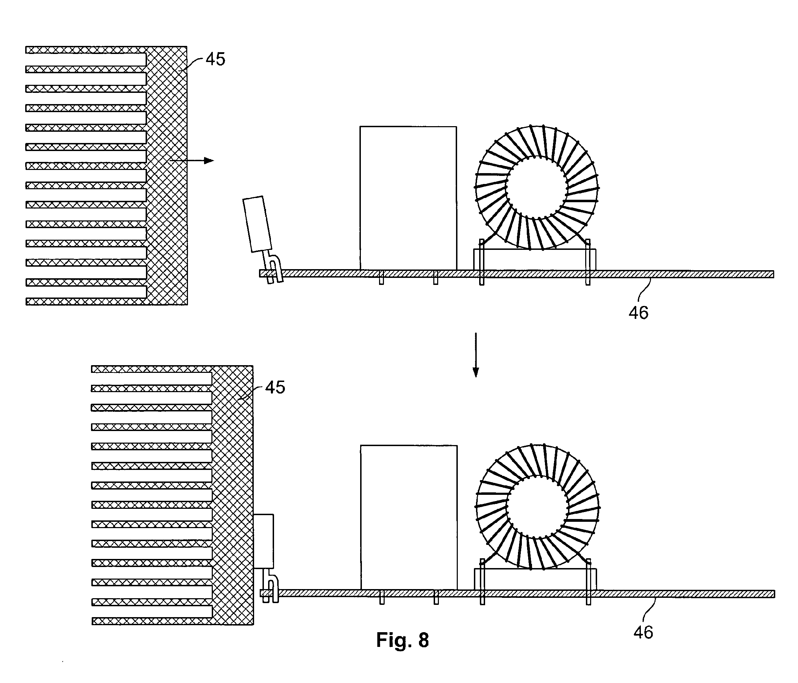

However, electric power modules 62 with lateral pin design have serious drawbacks in terms of processability, assembly, service life and safety owing to their configuration and construction. These shortcomings are described with reference to Fig. 7 and 8.

An electric power module with lateral pin design comprises an assembly surface on which a heat-dissipating element, for example a heat sink, can be provided. The power module is conventionally first of all soldered to a printed circuit board before the heat sink is provided on the assembly surface of the power module. However if the power module is not positioned on the printed circuit board such that a right angle to the printed circuit board is exactly achieved, the application of the heat sink to the assembly surface of the power module leads to potential bending of the soldered connecting pins or at least to inadmissibly high tensile forces in the connecting pins. If the power modules are not fixed during the soldering process, there is a risk that the connections will be bent or deformed after the heat sink has been attached. This can damage the solderings of the connections and lead to early failures. Fixing aids are therefore used during the soldering process to ensure a right angle between a longitudinal axis of the connecting pins of the power module and the printed circuit board. These fixing aids are complex however and associated with additional costs.

According to the prior art, power modules for upright construction conventionally comprise a circuit carrier which is constructed as a superimposition of an aluminum layer 91, epoxide layer 92 and copper layer 93, as can be seen in Fig. 7. The coefficient of thermal expansion of a circuit carrier of this kind is conventionally not adapted to the silicon chips 94 and bonding wires 95. The circuit carrier provided with the chips is moreover surrounded by a plastic material-based casting compound. A transfer moulding compound or casting compound of this kind conventionally has a greater coefficient of thermal expansion than the silicon chips or the circuit carrier. Above a certain module size use of a hard casting compound therefore causes high shearing forces at the wire bonding sites and encased components. Consequently use of a hard casting compound and a circuit carrier coated with aluminum-epoxide-copper leads to a severe reduction in the service life of an electric power module.

Furthermore a circuit carrier according to the prior art is not safe in the event of destruction of the assembled power semi-conductors. If power semi-conductors are destroyed heating usually occurs in which the epoxide insulation 92, which is only a few micrometers thick, burns. As a consequence the housing base is directly connected to the mains voltage since the pins of the power module conduct mains voltage during use. The requisite air gaps and creepage distances are not maintained between the pins and heat sink and between the connecting pins because of the low height of the housing.

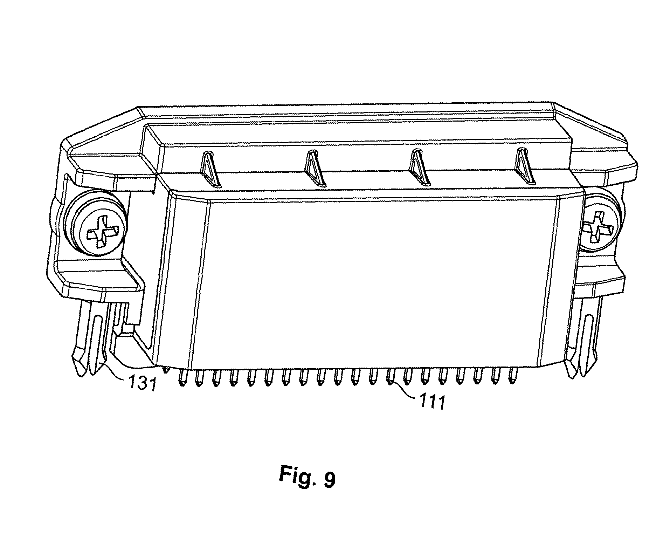

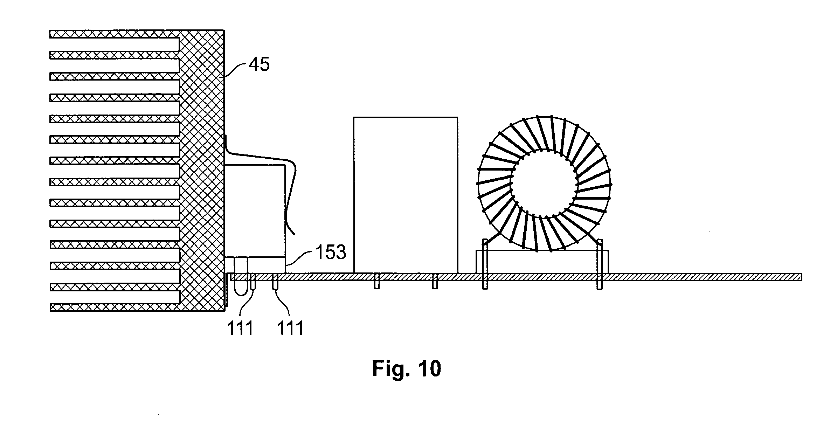

German patent application DE 10 2005 026 233.3 discloses a power module, of which the construction is shown in a perspective view in Fig. 9. Fig. 10 shows the known power module in an assembled position on a printed circuit board. The power module described in the above-stated application comprises a mechanical fixing device, such as a board lock 131, for fixing to the printed circuit board. Other envisaged mechanical fixing devices comprise a screw connection or a holding foot 153 for supporting the power module on the printed circuit board. These mechanical fixing devices allow right-angled assembly of the power module on the printed circuit board, so when assembling the cooling element 45 on the assembly surface of the power module compressive forces or even bending of the connecting pins are prevented. The solderings of the connecting pins on the printed circuit board are therefore not mechanically overloaded.

The described, vertical power module is configured for soldering onto the printed circuit board. Connecting pins 111 are led out of the power module and introduced into corresponding holes in the printed circuit board and then soldered. Since the power module has to be soldered the power module is rigidly connected to the printed circuit board. The power module soldered to the printed circuit board can only be replaced with difficulty, for example following a failure, so repair of an electric power device that receives the power module is rendered difficult. Solder-free assembly would therefore be desirable to simplify the construction of the electric power device.

The object of the invention is therefore to improve an electric power module and an electric power device that receives the electric power module to the extent that the electric power module has a simplified assembly in the electric power device.

According to the present invention this object is achieved by an electric power module with the features of claim 1 and an electric power device with the features of claim 16.

Advantageous developments of the present invention are the subject matter of the subclaims.

As a result of the fact that the electric power module according to the present invention includes at least one plug-in device for attaching the power module to the printed circuit board, the power module can be easily attached to the printed circuit board, so solder-free assembly of the electric power module on the printed circuit board is possible. With this kind of solder-free assembly of the electric power module, tolerances, which lead to distortions in the case of a conventionally soldered connection, can be compensated.

The electric power module according to the invention also simplifies the construction of an electric power device that receives the power module according to the invention since the electric power module can be easily replaced in the event of repairs because of the solder-free connection to the printed circuit board of the electric power device.

The right angle between the assembly surface of the cooling element and the plane of the printed circuit board can also be achieved without resulting in a rigid connection as in the electric power module disclosed in DE 10 2005 026 233.3. The electric power module according to the invention in particular allows a cooling element provided on the assembly surface of the circuit carrier to be assembled at a right angle to the printed circuit board without the connecting pins of the electric power module being fixed on the printed circuit board by a rigid solder joint.

If the at least one plug-in device comprises at least one spring contact which electrically connects the power module to the printed circuit board, solder-free electrical connection of the electric power module to the printed circuit board is achieved. This avoids a cooling element provided on the circuit carrier of the electric power module mechanically overloading the electrical terminal pads between the power module and the printed circuit board, as was the case in conventional power modules. Early failures of the electrical connection of the electric power module to the printed circuit board can thus be avoided.

Either a pure plug-in connection of the spring contact with the printed circuit board or a connection with cold welding, similar to a press-in contact, can moreover be created, depending on the spring force of the spring contact.

According to a further embodiment of the invention, the at least one plug-in device comprises a first part and a second part which are adapted in such a way that the printed circuit board can be introduced into the power module between the first part and the second part.

If a first spring contact is provided on the first part of the plug-in device and a second spring contact on the second part of the plug-in device in such a way that the first spring contact and the second spring contact electrically connect the power module to the introduced printed circuit board, there is an electrical connection on two sides of the printed circuit board.

According to one embodiment of the electric power module according to the invention a large number of first spring contacts is provided in series on the first part of the plug-in connection. A single-row electrical connection between the electric power module and the printed circuit board is therefore produced on one side of the printed circuit board by a series of first spring contacts.

According to a further embodiment of the electric power module according to the invention a large number of second spring contacts is provided in series on the second part of the plug-in device. A two-row electrical connection between the electric power module and the printed circuit board is therefore produced on two sides of the printed circuit board.

According to one embodiment of the invention the at least one spring contact comprises at least one locking mechanism for mechanical strain relief. According to an alternative embodiment of the present invention the housing comprises at least one clip connection for mechanical strain relief. A printed circuit board introduced into the power module can thus be fixed and the electrical connection between the power module and the printed circuit board be ensured even in the event of mechanical pressure or tensile force.

If the circuit carrier of the power module is provided with at least one electronic component on one side and the cooling element can be provided on the opposing side, then the heat generated by the at least one electronic component can be transferred by the heat-conducting circuit carrier and can be dissipated by the heat-conducting cooling element. Such a configuration of the electric power module is particularly advantageous if the power module is used in an electric power device where a high quantity of heat is to be dissipated.

As a result of the fact that the second part of the plug-in device is used for electrically insulating the cooling element from the printed circuit board and the at least one spring contact, the required air gaps and creepage distances according to relevant EN, IEC and UL standards can be observed. Since the connecting pins of the power module, i.e. the spring contacts, conduct mains voltage during use, they have to be insulated from the most contactable heat sink by adequate air gaps and creepage distances. For this purpose a sufficient spacing is attained between the connecting pins of the power module and the cooling element by the second part of the plug-in device. The second part of the plug-in device is preferably provided as part of the housing, which is arranged between the connecting pins and the cooling element.

According to an advantageous embodiment of the electric power module the circuit carrier is constructed as a planar, heat-conducting carrier plate. Faultless assembly of the cooling element with respect to the circuit carrier may thus be ensured and if the cooling element is constructed for example as a heat sink, optimum heat transference can be ensured between the circuit carrier of the power module and the cooling element.

If the circuit carrier is provided as a carrier plate made of ceramics, preferably thick-film ceramics, hybrid ceramics or Direct Copper Bonding ("DCB") ceramics, the circuit carrier provided with an electronic component is produced from a thermally indestructible insulating material, and this is particularly important in an electric power module operated on the mains voltage. The circuit carrier is moreover preferably made from a material, such as hybrid ceramics or DCB ceramics, which allows a low-voltage solder joint when an electronic component is used, of which the edge length is greater than two millimetres, by way of a thermal linear coefficient of expansion adapted to the electronic component. An improved electric power module service life can therefore be achieved.

The safety of an electric power module can moreover be improved if the circuit carrier is made from ceramics. In contrast to a circuit carrier made of aluminum-epoxide-copper in which the thin epoxide insulation burns in the event of destruction of a power semi-conductor and the circuit carrier can be directly connected to the mains voltage, the circuit carrier made from a thermally indestructible insulating material, such as ceramics, is not directly connected to the mains voltage if the power semi-conductor is destroyed.

According to a further advantageous embodiment of the electric power module according to the invention the power module comprises a plastic material housing which is lined with a soft, resilient casting compound and at least partially surrounds the circuit carrier. A casting compound of this kind is used to protect the at least one electronic component on the circuit carrier and the circuit carrier itself from moisture and soiling. Since the casting compound is soft and resilient no distortions or shearing forces occur between the circuit carrier, the at least one electronic component and the bonding wires which secure the electronic component to the circuit carrier. The service life of the electric power module according to the invention is increased thereby.

If the electric power module according to the invention is fitted in an electric power device which comprises a printed circuit board and a cooling element with a planar surface, the cooling element being provided on the circuit carrier of the electric power module, a particularly compact electric power device can be produced. The production method of an electric power device of this kind is moreover simplified by the incorporation of the electric power module according to the invention as the power module can be attached to the printed circuit board by the at least one plug-in device. Repairing an electric power device of this kind is also considerably simplified since the electric power module can be easily replaced due to the solder-free connection to the printed circuit board.

The invention will be described in more detail hereinafter with reference to the embodiments shown in the accompanying drawings. Similar or corresponding details of the electric power module according to the invention are provided with the same reference numerals in the figures, in which:
Fig. 1 shows a schematic view of an electric power device according to the prior art,
Fig. 2 shows a further schematic view of an electric power device according to the prior art,
Fig. 3 shows a further schematic view of an electric power device according to the prior art,
Fig. 4 shows a side view of a known electric power module,
Fig. 5 shows a side view of a known electric power module with lateral pin design,
Fig. 6 shows a front view of the known electric power module shown in Fig. 5 with lateral pin design,
Fig. 7 shows a plan view of a known electric power module according to figures 5 and 6,
Fig. 8 shows a schematic view of the assembly of a heat sink on an electric power device according to the prior art with power module not positioned at a right angle,
Fig. 9 shows a perspective view of a conventional electric power module,
Fig. 10 shows a schematic view of an electric power device which receives the conventional electric power module shown in Fig. 9,
Fig. 11 shows a cross-section through an electric power module according to a first embodiment of the present invention,
Fig. 12 shows a front view of an electric power module according to a second embodiment of the present invention,
Fig. 13 shows a cross-section through an electric power module according to a third embodiment of the present invention,
Fig. 14 shows a cross-section through a plug-in device of an electric power module according to one embodiment of the invention,
Fig. 15 shows a cross-section through a plug-in device of an electric power module according to a further embodiment of the invention,
Fig. 16a shows a front view of an electric power module according to a further embodiment of the present invention,
Fig. 16b shows a cross-section through the electric power module shown in Fig. 16a,
Fig. 17a shows a front view of an electric power module according to a further embodiment of the present invention,
Fig. 17b shows a cross-section through the electric power module shown in Fig. 17a.

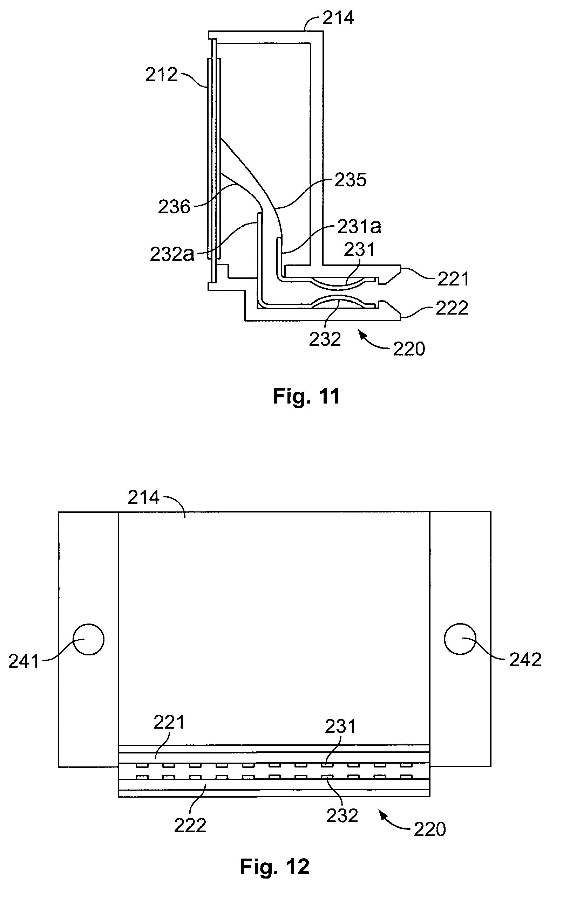

As may be seen from Fig. 11 the electric power module according to the invention comprises a circuit carrier 212 which is partially surrounded by a housing 214. The housing 214 is preferably made from plastic material. The housing 214 comprises a plug-in device 220 which is arranged on one end of the housing 214. The plug-in device 220 comprises a first part 221 and a second part 222 which project from the main body of the housing 214.

According to one embodiment of the invention, a first spring contact 231 is arranged on the first part 221 of the plug-in device 220 and a second spring contact 232 on the second part 222 of the plug-in device 220, so a two-row electrical connection of the power module with an introduced printed circuit board is possible. In Fig. 11 the first spring contact 231 and the second spring contact 232 are each connected by an appropriate first bonding wire 235 and second bonding wire 236 to the circuit carrier 212.

The first part 221 and the second part 222 of the plug-in device 220 are arranged in such a way that in particular the spacing between their respective free ends is selected to fit a printed circuit board (not shown in Fig. 11) which is introduced into the power module. A respective longitudinal axis of the first part 221 and the second part 222 of the plug-in device 220 of the electric power module shown in Fig. 11 runs substantially perpendicular to the plane of the circuit carrier 212. A printed circuit board (not shown) introduced into the electric power module is therefore secured substantially perpendicular to the plane of the circuit carrier 212.

The first spring contact 231 and the second spring contact 232 are each provided on the respective inner surface of the first part 221 and second part 22 inside the housing 214. The respective longitudinal axis of the first spring contact 231 and second spring contact 232 runs substantially parallel to the longitudinal axis of the first and second parts 221, 222 of the plug-in device 220. The first and second spring contacts 231, 232 each comprises a part 231a, 232a bent at a right angle and which runs substantially parallel to the plane of the circuit carrier 212. Each part 231a, 232a bent at a right angle is connected by a bonding wire 235, 236 to the circuit carrier 212 respectively.

The first spring contact 231 and the second spring contact 232 produce the electrical connection to the introduced printed circuit board. An electric power module according to the present invention can thus be easily attached to a printed circuit board, and this allows solder-free connection of the electric power module to the printed circuit board.

Fig. 12 shows a front view of the power module shown in Fig. 11. The plug-in device 220 for attaching the power module to a printed circuit board comprises the first part 221 and second part 222, shown in Fig. 11, on the respective inner faces of which a large number of corresponding first spring contacts 231 and second spring contacts 232 are provided in series.

As may be seen in Fig. 12, holes 241, 242 can also be provided in the power module, preferably at both its ends, to allow screw assembly of the power module with respect to the cooling element.

The second part 222 of the plug-in device 220 arranged between the first and second spring contacts 231, 232 and the cooling element ensure that the required air gaps and creepage distances for electrical insulation according to relevant EN, IEC and UL standards are observed.

According to an advantageous embodiment of the electric power module according to the invention the housing 214 shown in Fig. 11 is lined with a casting compound which is used to protect the semi-conductor elements assembled on the circuit carrier 212 from moisture and soiling. This casting compound is provided in the form of a soft, resilient casting compound. No distortions or shearing forces occur between the circuit carrier 212, the semi-conductor elements assembled on the circuit carrier 212 and the bonding wires 235 because of the soft casting compound.

Although the first and second spring contacts 231, 232 are arranged in two rows in the plug-in device 220 in the figures 11 and 12, the present invention is not limited to just a two-row pin design but can also be used for a single-row pin design or for any desired type of pin design.

The circuit carrier 212 is preferably constructed in the form of a planar heat-conducting carrier plate which comprises a thermally indestructible insulation material of sufficient thickness. The circuit carrier 212 is preferably produced from ceramics, thick-film ceramics or DCB ceramics. On the side of this carrier plate made from ceramics and which is located inside the housing 214 are arranged electronic components which are electrically connected to the first and second spring contacts 231, 232. The other side of the carrier plate is arranged in direct contact with a cooling element in an assembled position. This cooling element is a heat sink for example but can also be the housing of a device that is to be controlled, for example an electric motor.

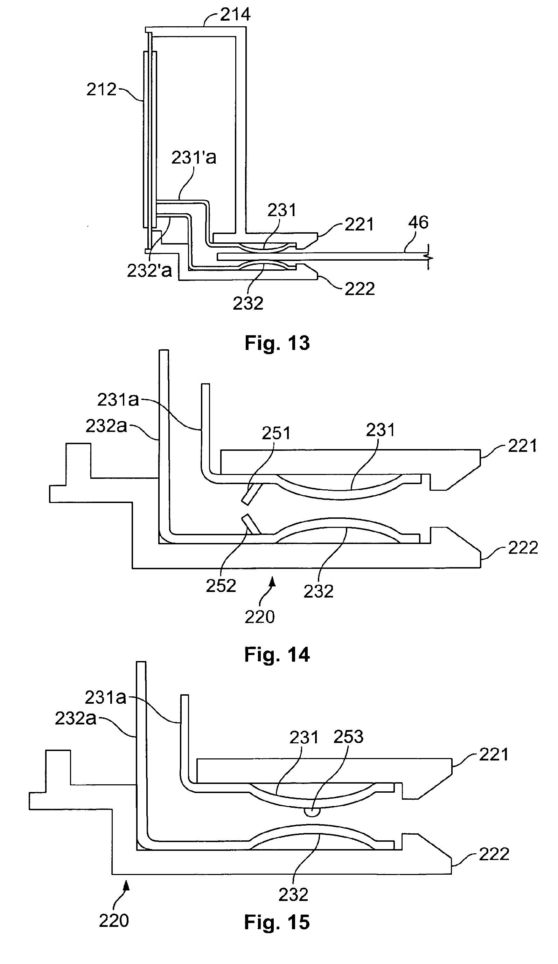

Fig. 13 shows a further embodiment of the electric power module according to the present invention. Fig. 13 shows how the electric power module is attached to the printed circuit board 46. The first spring contact 231 and the second spring contact 232 are electrically connected using appropriate electrical contacts provided on the printed circuit board 46. According to a further embodiment of the invention the first spring contact 231 and the second spring contact 232 each comprise a part 231'a, 232'a that has been bent twice at right angles and of which the free ends are directly soldered to the circuit carrier 212.

Although the spring contacts in the embodiments of the present invention shown in figures 11 and 13 are bonded (Fig. 11) or soldered (Fig. 13) to the circuit carrier 212 other electrical connections can of course be used, such as welding, gluing, pressing-on or plugging of the spring contacts to the circuit carrier 212.

Fig. 14 shows an enlarged view of the plug-in device 220 of the electric power module according to an embodiment of the present invention. A first locking mechanism 251 and a second locking mechanism 252 are each incorporated in the first spring contact 231 and second spring contact 232. The respective locking mechanism 251, 252 is incorporated in the spring contact between the first or second spring contact 231, 232 and the respective part 231a, 232a bent at a right angle. The first and second locking mechanisms 251, 252 are used for fixing the introduced printed circuit board to allow mechanical strain relief of the first and second spring contacts 231, 232. The first and second locking mechanisms 251, 252 can be adapted for example such that they can latch in corresponding holes in the printed circuit board. Other fixings are also possible however.

Fig. 15 shows an alternative embodiment of the plug-in device 220, a locking device 253 being incorporated in the first spring contact 231. The locking mechanism 253 is used for fixing the introduced printed circuit board to allow strain relief of the first spring contact 231. The locking mechanism 253 can be latched in a corresponding hole in the printed circuit board.

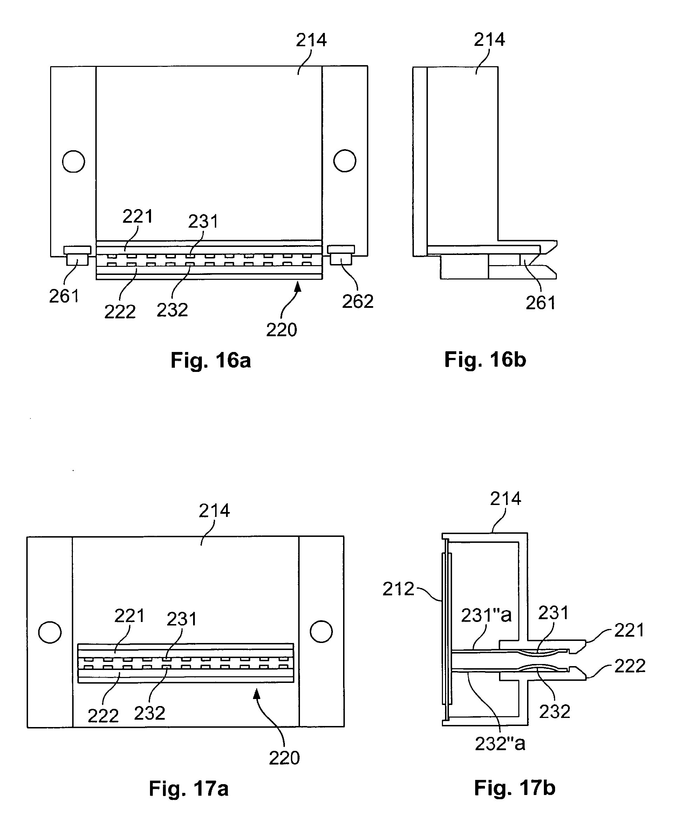

Fig. 16a shows a front view of a power module according to a further embodiment of the present invention. The housing 214 comprises a first clip element 261 at one end of the plug-in device 220 and a second clip element 262 at the other end of the plug-in device 220. The first and second clip elements 261, 262 are used for fixing the introduced printed circuit board, so mechanical strain relief of the plug-in device 220 is made possible.

Fig. 16b shows a side view of the electric power module, it being possible to see the first clip element 261 provided on the housing 214.

Fig. 17a shows a front view of the electric power module according to an advantageous embodiment of the present invention, the plug-in device 220 not being arranged on the lower end of the housing 214 but at any desired level of the housing 214.

Fig. 17b shows a cross-section of the electric power module shown in Fig. 17a. The plug-in device 220 is arranged at a level of the housing 214 in such a way that a substantially straight first spring contact 231 and second spring contact 232 produce the electrical connection to the circuit carrier 212. This advantageous arrangement of the plug-in device 220 on the housing 214 means the construction of the first and second spring contacts 231, 232 can be simplified since the respective parts bent at a right angle and shown in figures 11 and 13 are not necessary.

The electric power module according to the present invention comprises at least one plug-in device for attaching the power module to a printed circuit board. Assembly of the electric power module on the printed circuit board of an electric power device is therefore simplified since solder-free connection is possible. Moreover, with this kind of solder-free assembly of the electric power module, tolerances, which lead to distortions in the case of a conventionally soldered connection, can be compensated.

## Claims

1. Electric power module for assembly on a printed circuit board (46), comprising:
a circuit carrier (212) and a housing (214) for assembly of a cooling element (45), wherein the circuit carrier (212) is arranged on the printed circuit board (46) so as to be substantially perpendicular thereto in an assembled position of the electric power module, and
at least one plug-in device (220) for attaching the power module to the printed circuit board (46).

2. Electric power module according to claim 1, wherein the at least one plug-in device (220) comprises at least one spring contact (231, 232) which electrically connects the power module to the printed circuit board (46).

3. Electric power module according to claim 1 or 2, wherein the at least one plug-in device (220) comprises a first part (221) and a second part (222) which are adapted such that the printed circuit board (46) can be introduced into the power module between the first part (221) and second part (222).

4. Electric power module according to claim 3, wherein a first spring contact (231) is provided on the first part (221) of the plug-in device (220) and a second spring contact (232) is provided on the second part (222) of the plug-in device (220) in such a way that the first spring contact (231) and second spring contact (232) electrically connect the power module to the introduced printed circuit board (46).

5. Electric power module according to claim 3 or 4, wherein a large number of first spring contacts (23 1) is provided in series on the first part (221) of the plug-in device (220).

6. Electric power module according to claim 5, wherein a large number of second spring contacts (232) is provided in series on the second part (222) of the plug-in device (220).

7. Electric power module according to claims 3 to 6, wherein the second part (222) of the plug-in device (220) is used for electrically insulating the cooling element (45) of the printed circuit board (46) and the at least one spring contact (231, 232).

8. Electric power module according to any one of claims 1 to 7, wherein the circuit carrier (212) is provided on one side with at least one electronic component (181) and the cooling element (45) can be attached to the opposing side.

9. Electric power module according to claim 8, wherein the at least one spring contact (231, 232) is electrically connected to the at least one electronic component (181).

10. Electric power module according to any one of claims 1 to 9, wherein the at least one spring contact (231, 232) comprises at least one locking mechanism (251, 252, 253) for mechanical strain relief.

11. Electric power module according to any one of claims 1 to 10, wherein the housing (214) comprises at least one clip connection (261, 262) for mechanical strain relief.

12. Electric power module according to any one of claims 1 to 11, wherein the circuit carrier (212) is constructed as a planar, heat-conducting carrier plate.

13. Electric power module according to any one of claims 1 to 12, wherein the circuit carrier (212) is constructed as a carrier plate made of ceramics, preferably thick-film ceramics, hybrid ceramics or DCB ceramics.

14. Electric power module according to any one of claims 1 to 13, wherein the housing (214) is made from plastic material and at least partially surrounds the circuit carrier (212).

15. Electric power module according to any one of claims 1 to 14, wherein the housing (214) is lined with a soft, resilient casting compound (182).

16. Electric power device comprising an electric power module according to any one of claims 1 to 15, a printed circuit board (46) and a cooling element (45), wherein the cooling element (45) has a planar surface and is provided on the circuit carrier (212) of the electric power module.

17. Electric power device according to claim 16, wherein the cooling element (45) is constructed as a heat sink.
